**Europäisches Patentamt**

**European Patent Office**

**Office européen des brevets**

(11) Veröffentlichungsnummer: **0 226 006**
**A1**

(12) # EUROPÄISCHE PATENTANMELDUNG

(21) Anmeldenummer: **86114949.0**

(22) Anmeldetag: **28.10.86**

(51) Int. Cl.⁴: **H 03 F 3/217**

(30) Priorität: **26.11.85 DE 3541663**

(43) Veröffentlichungstag der Anmeldung:
**24.06.87 Patentblatt 87/26**

(84) Benannte Vertragsstaaten:
**CH DE FR GB LI**

(71) Anmelder: **Licentia Patent-Verwaltungs-GmbH**
**Theodor-Stern-Kai 1**
**D-6000 Frankfurt/Main 70(DE)**

(72) Erfinder: **Weber, Klaus, Dipl.-Ing.**
**Grüntaler Strasse 8**
**D-1000 Berlin 65(DE)**

(74) Vertreter: **Schulze, Harald Rudolf, Dipl.-Ing. et al,**
**Licentia Patent-Verwaltungs-GmbH Theodor-Stern-Kai 1**
**D-6000 Frankfurt/Main 70(DE)**

(54) **Schaltverstärker für analoge NF-Signale.**

(57) Die Erfindung betrifft einen Schaltverstärker für analoge NF-Signale, insbesondere zum Erzeugen einer modulierten Anodenspannung für eine Hochfrequenzsenderendstufe. Dabei wird eine Anordnung aus mehreren parallel und seriell geschalteten Halbleiter-Schaltern (S1-S8) benutzt, um ein pulsdauermoduliertes Ausgangssignal (U1) zu erzeugen. Im Vergleich dazu wird jeder der Halbleiterschalter (S1-S8) jeweils mit einem Steuersignal angesteuert, das eine niedrige Schaltfrequenz verursacht.

FIG. 1

EP 0 226 006 A1

0226006

Licentia Patent-Verwaltungs-GmbH          PTL-UL/Ja/rß
Theodor-Stern-Kai 1                        UL 85/66
D-6000 Frankfurt 70


Beschreibung


## Schaltverstärker für analoge NF-Signale

Die Erfindung betrifft einen Schaltverstärker für NF-
Signale nach dem Oberbegriff des Patentanspruchs 1.

Ein derartiger Schaltverstärker ist bekannt aus der deutschen Patentschrift 1 218 557. Dort ist eine Schaltung aus
mehreren parallel geschalteten Röhren angegeben, die durch
ein Steuergerät mit jeweils einem Steuersignal angesteuert
werden, das als Pulsfolge ausgebildet ist. Zwischen diesen
Pulsfolgen besteht eine zeitliche Verschiebung. Ein derartiger Schaltverstärker ist insbesondere verwendbar als
Modulationsschaltung für eine Hochfrequenzsenderendstufe,
bei der eine Anodenspannungsmodulation durchgeführt wird.
Für einen Hochleistungssender mit einer beispielhaften

...

abgebbaren Leistung von ungefähr 500 kW ist es erforderlich, daß der Schaltverstärker eine Spitzenleistung von ungefähr 2MW schaltet bei einer Gleichspannung von ungefähr 30kV. Aus wirtschaftlichen Gründen ist es nun naheliegend, die in einem solchen Schaltverstärker vorhandenen Röhren durch entsprechende Halbleiter-Bauelemente, z.B. Halbleiter-Schalter, zu ersetzen. Derartige Halbleiter-Schalter besitzen für die angegebene Spitzenspannung derzeit in nachteiliger Weise Schaltzeiten, die ungefähr einige μsec betragen. Bei derart langen Schaltzeiten und bei den erforderlichen hohen Pulsfolgefrequenzen von z.B. 52 kHz entstehen in den Halbleiter-Schaltern sehr hohe störende Verlustleistungen, z.B. als Wärme, die lediglich mit hohem wirtschaftlichen Aufwand abführbar sind oder sogar zur Zerstörung des Halbleiter-Schalters führen.

Der Erfindung liegt daher die Aufgabe zugrunde, einen gattungsgemäßen Schaltverstärker dahingehend zu verbessern, daß Halbleiter-Schalter in zuverlässiger sowie kostengünstiger Weise einsetzbar sind, insbesondere bei einem Hochleistungssender.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein erster Vorteil der Erfindung besteht darin, daß bei einem Halbleiter-Schalter die Schaltfrequenz wesentlich geringer ist als die Abtastfrequenz und kleiner ist als die Schaltfrequenz eines Teilgerätes.

...

Dadurch entsteht eine wesentlich verringerte Verlustleistung in jedem Halbleiter-Schalter, die in kostengünstiger sowie zuverlässiger Weise abführbar ist.

Ein zweiter Vorteil besteht darin, daß zum Schalten der eingangs erwähnten Gleichspannung mindestens zwei Halbleiter-Schalter hintereinander geschaltet sind. Dadurch ist es möglich, einen der Halbleiter-Schalter immer zum Einschalten der Gleichspannung zu verwenden, während der andere immer zum Ausschalten verwendet wird. Es ist daher möglich, Halbleiter-Schalter zu verwenden, die besonders für diese Schaltvorgänge hergestellt sind.

In dieser Patentanmeldung umfaßt der Begriff "Halbleiter-Schalter" nicht nur das eigentliche Halbleiterbauelement, z.B. Leistungsthyristor und -Transistor, sondern auch dessen Beschaltung, z.B. entsprechende Treiberstufen. Denn durch diese äußere Beschaltung wird das Schaltverhalten, z.B. die Ein- und/oder Ausschaltzeiten sowie die entstehende Verlustwärme, in wesentlicher Weise mitbestimmt.

Die Erfindung wird im folgenden anhand von Ausführungsbeispielen näher erläutert unter Bezugnahme auf eine schematische Zeichnung. Es zeigen

FIG. 1    ein schematisches Blockschaltbild eines Ausführungsbeispiels;

FIG. 2    ein Diagramm zur Erläuterung der Funktionsweise des Ausführungsbeispiels.

...

Fig. 3      ein zweites Ausführungsbeispiel

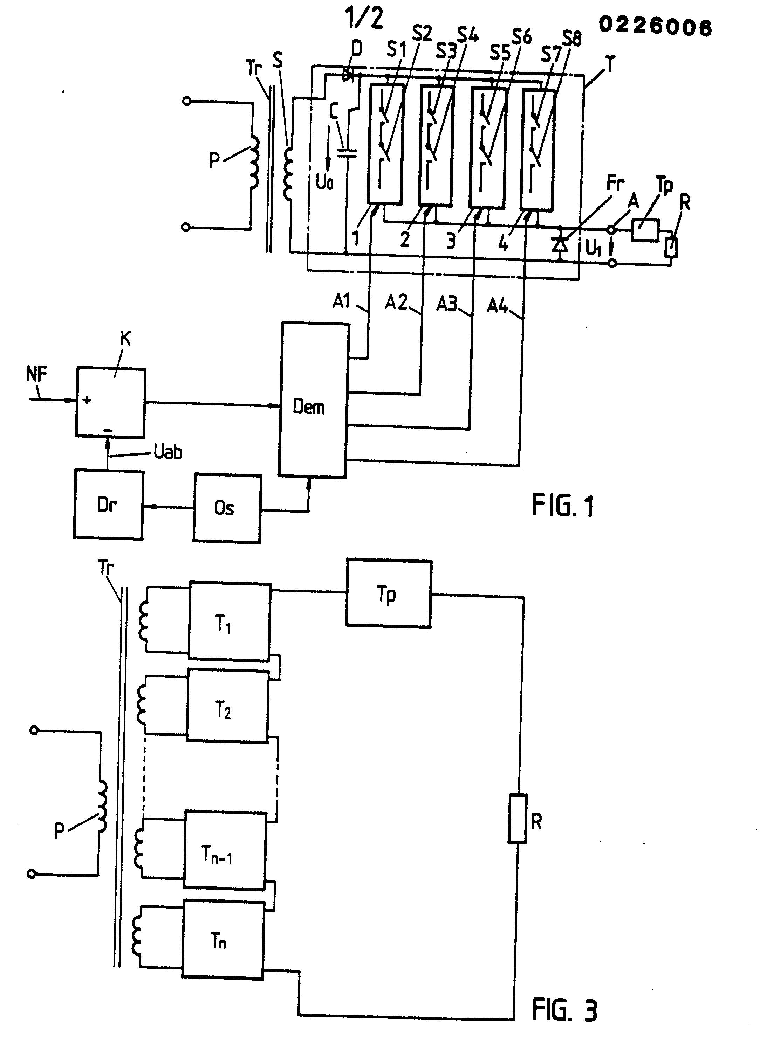

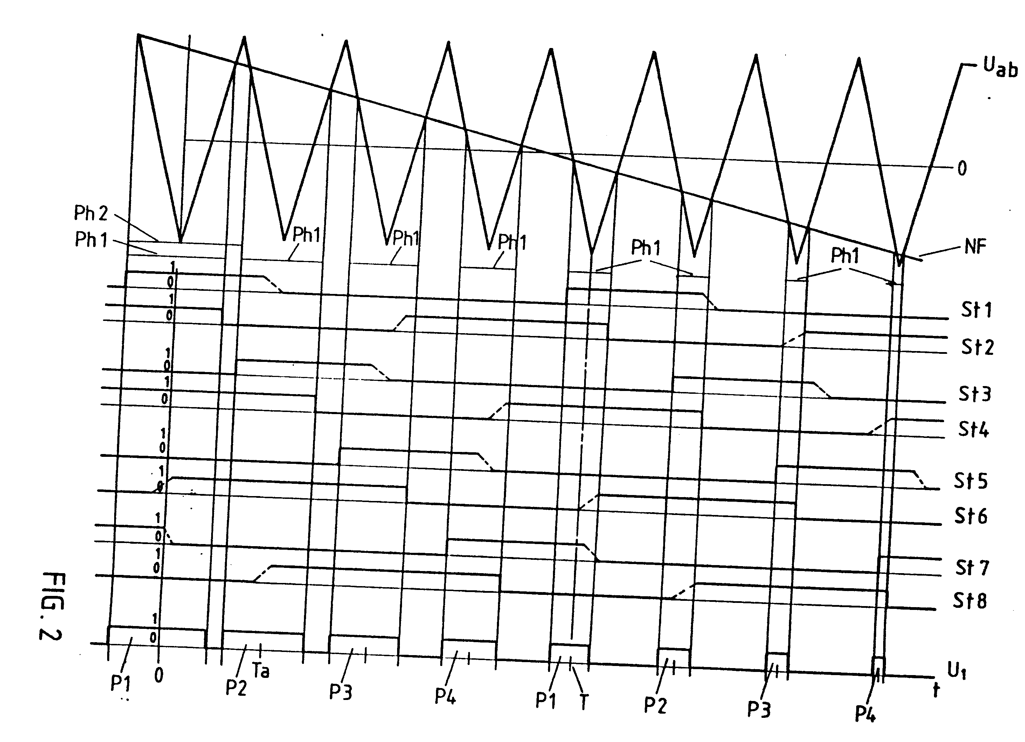

Fig. 1 zeigt einen Netztransformator Tr, dessen Primärseite P z.B. an ein 220V-50Hz-Netz angeschlossen ist und
dessen Sekundärseite S eine wesentlich höhere Wechselspannung, z.B. 1kV, erzeugt. Dabei ist die maximale Spannung dieser Wechselspannung abhängig von der maximalen
Schalt- und/oder Sperrspannung der verwendeten Halbleiter-
Schalter.

An die Sekundärseite S ist ein Teilnetzgerät T angeschlossen, dessen Ausgang A über ein Tiefpaßfilter Tp mit einer
Last R verbunden ist. Das Tiefpaßfilter ist z.B. als T-
oder Pi-Glied aufgebaut und besitzt eine bespielhafte
Grenzfrequenz von ungefähr 7,5 kHz, so daß an der Last R
lediglich das verstärkte NF-Signal anliegt.

In dem Teilnetzgerät T wird die sekundäre Wechselspannung
zunächst durch eine Gleichrichterdiode D gleichgerichtet
und einem Glättungskondensator C zugeführt. An diesem
entsteht eine Gleichspannung $U_o$, z.B. ungefähr 1,2 kV, die
zur Erzeugung eines pulsdauermodulierten Ausgangssignals
$U_1$ durch beispielsweise acht Halbleiter-Schalter S1 bis S8
geschaltet wird. Diese sind in vier Schaltergruppen 1 bis
4 zusammengefaßt, die durch eine Parallelschaltung elektrisch verbunden sind. Jede der Schaltergruppen 1 bis 4
enthält eine Hintereinanderschaltung (Serienschaltung) aus
zwei Halbleiter-Schaltern. So enthält beispielsweise die
Schaltergruppe 1 eine Serienschaltung der Halbleiter-
Schalter S1, S2. Die elektrische Ansteuerung der Schaltergruppen erfolgt beispielsweise durch folgende Anordnung.

...

Bei einem Komparator K liegt an dessen einen Eingang + das zu verstärkende NF-Signal, das z.B. eine Bandbreite von 7,5 kHz und eine maximale Spitze-Spitze-Spannung von 1 Volt besitzt. An dem anderen Eingang - liegt eine Abtastspannung $U_{ab}$, die als sogenannte Dreiecksspannung ausgebildet ist mit einer beispielhaften Spitze-Spitze-Spannung von größer 1 Volt, z.B. 1,1 Volt - was nachfolgend erläutert wird - und einer Grundfrequenz von z.B. 50 kHz.

Diese Abtastspannung $U_{ab}$ wird z.B. aus einem entsprechenden Rechtecksignal gewonnen, das in einem Taktoszillator Os erzeugt wird. Das Ausgangssignal des Komparators K wird einem durch den Taktoszillator Os zyklisch umgeschalteten Demultiplexer Dem zugeführt, dessen Ausgänge A1 bis A4 jeweils mit einer Schaltergruppe 1 bis 4 verbunden sind.

Fig. 2 zeigt im oberen Teil die dreieckförmige Abtastspannung $U_{ab}$ sowie eine beispielhaft gewählte linear abfallende NF-Spannung. Im unteren Teil sind die zu den Halbleiter-Schaltern S1 bis S8 gehörenden Steuersignale St1 bis St8 dargestellt, welche den Schaltzuständen der Halbleiter-Schalter entsprechen. Dabei bedeutet "1" bzw. "0" einen geschlossenen bzw. einen geöffneten Halbleiter-Schalter. Durch Addition der Steuersignale St1 bis St8 entsteht das entsprechende pulsdauermodulierte Ausgangssignal $U_1$, dessen Periodendauer Ta im wesentlichen gleich derjenigen der Dreiecksspannung ist. Im Bereich der Zeit t < 0 schaltet der Komparator K (Fig. 1) , wenn das NF-Signal von der abfallenden Flanke der Abtastspannung $U_{ab}$ gekreuzt wird.

0226006

Dadurch wird über das Steuersignal St1 der zugehörigen Halbleiter-Schalter S1 eingeschaltet. Am Schnittpunkt der ansteigenden Flanke der Abtastspannung $U_{ab}$ mit dem NF-Signal wird über das Steuersignal St2 der Halbleiter-Schalter S2 ausgeschaltet. Im Ausgangssignal $U_1$ entsteht daher ein Puls P1, dessen Pulsdauer von einer ersten Phasenverschiebung Ph1 zwischen den Steuersignalen St1, St2 abhängt, die zu einer Schaltergruppe 1 gehören. Bei der nächsten abfallenden Flanke der Abtastspannung $U_{ab}$ wird der Demultiplexer Dem (Fig. 1) auf die folgende Schaltergruppe 2 geschaltet, so daß nun die dortigen Halbleiter-Schalter S3, S4 wie beschrieben geschaltet werden, so daß der Puls P2 entsteht. Entsprechendes gilt für die Schaltergruppen 3, 4. Zwischen den Steuersignalen benachbarter Steuergruppen entsteht daher eine zweite Phasenverschiebung Ph2. Das Ausschalten der Halbleiter-Schalter S1, S3, S5, S7 erfolgt nach einer Zeit, die größer ist als die Ausgangs-Periodendauer Ta. Ein derartiger Ausschaltvorgang ist z.B. mit Hilfe eines entsprechend getriggerten Monoflop-Bauelementes möglich. In den Steuersignalen St1, St3, St5, St7 sind die entsprechenden Schaltpunkte gestrichelt dargestellt. Das in den Steuersignalen St2, St4, St6, St8 gestrichelt dargestellte Einschalten der zugehörigen Halbleiter-Schalter S2, S4, S6, S8 ist ebenfalls mit Hilfe eines entsprechend getriggerten Monoflop-Bauelements möglich. Aus Fig. 2 ist ersichtlich, daß jeder Halbleiter-Schalter mit einer Wiederholfrequenz von 15kHz:4 (Anzahl der Schaltergruppen) = 3.75 kHz geschaltet wird, welche der Periodendauer T entspricht. Diese Wiederholfrequenz ist vorteilhafterweise so klein, daß Leistungshalbleiter mit den eingangs erwähnten Schaltzeiten verwendbar sind

...

und deren Verlustwärme in wirtschaftlicher Weise abführbar ist. Es ist zweckmäßig, den maximalen Spitze-Spitze-Wert des NF-Signals kleiner zu wählen als denjenigen der Abtastspannung, denn dadurch wird sichergestellt, daß auch bei den Werten Oberstrich und Unterstrich Pulse im Ausgangssignal $U_1$ entstehen. Der Ausgang A des Teilnetzgerätes T ist mit einer sogenannten Freilaufdiode Tr abgeschlossen.

Die maximale Pulshöhe im Ausgangssignal $U_1$ ist durch die Eigenschaften. z.B. Sperrspannung, der verwendeten Halbleiter-Schalter begrenzt. Soll nun eine bespielhafte Pulshöhe von 30 kV erzeugt werden, so ist es möglich, mehrere der beschriebenen Teilnetzgeräte T hintereinanderzuschalten.

Fig. 3 zeigt ein solches Ausführungsbeispiel, bei dem ein Netztransformator Tr mit einer Primärwicklung P und mehreren Sekundärwicklungen vorhanden ist. Jede Skundärwicklung ist mit einem Teilnetzgerät $T_1$ bis $T_n$. z.B. n = 30, verbunden. die gleichartig entsprechend Fig. 1 aufgebaut sind. Die Ausgänge sind hintereinandergeschaltet, so daß die gewünschte Ausgangsspannung entsteht. Zur Ansteuerung der Halbleiter-Schalter ist es lediglich erforderlich, entsprechende Steuerleitungen parallel zu schalten, z.B. alle Steuerleitungen der Halbleiter-Schalter S1. Es ist nicht nötig, die in Fig. 1 beschriebene Steuerschaltung (K. Dr. Os, Dem) mehrfach auszuführen.

Die Erfindung ist nicht auf das beschriebene Ausführungs-

UL 80226006

beispiel beschränkt, sondern sinngemäß auf weitere anwendbar. Beispielsweise ist es möglich, die Zahl der Schaltergruppen zu vergrößern. Dadurch vergrößert sich im Ausgangssignal die Pulswiederholfrequenz. Dieses führt zu einer Vereinfachung des Tiefpaßfilters Tp, insbesondere bei einem Hochleistungs-Hochfrequenzsender.

**0226006**

Licentia Patent-Verwaltungs-GmbH
Theodor-Stern-Kai 1

D-6000 Frankfurt 70

PTL-UL/Ja/rß
UL 85/66

<u>Patentansprüche</u>

1. Schaltverstärker für analoge NF-Signale, insbesondere zum Erzeugen einer modulierten Anodenspannung für eine Hochfrequenzsenderendstufe, bei welchem mindestens zwei steuerbare Schalter vorhanden sind, die durch mindestens zwei zueinander phasenverschobene Steuersignale angesteuert werden, in denen ein zu verstärkendes NF-Signal enthalten ist, und die eine Gleichspannung ($U_o$) derart schalten, daß ein pulsdauermoduliertes Ausgangssignal ($U_1$) entsteht, <u>dadurch gekennzeichnet,</u>

- daß zum Schalten der Gleichspannung ($U_o$) mindestens zwei Schaltergruppen (1 bis 4) vorhanden sind, die durch eine Parallelschaltung elektrisch verbunden sind.

- daß jede der Schaltergruppen (1) eine elektrische Hintereinanderschaltung aus mindestens zwei Halbleiter-Schaltern (S1, S2) enthält und

. . .

daß jeder Halbleiter-Schalter (S1 bis S8) mit jeweils einem im wesentlichen periodischen Steuersignal (St1 bis St8) angesteuert wird, das als Rechteckschwingung ausgebildet ist mit einer Periodendauer (T), die gleich dem Produkt ist aus der Anzahl der Halbleiter-Schalter multipliziert mit der halben Ausgangssignal-Periodendauer (Ta) und das bei dem zugehörigen Halbleiterschalter eine Einschaltdauer bewirkt, die größer ist als die Ausgangssignal-Periodendauer (Ta).

2. Schaltverstärker nach Anspruch 1, dadurch gekennzeichnet,

   - daß jedem Halbleiter-Schalter (S1, S2) einer zugehörigen Schaltergruppe (1) jeweils ein Steuersignal (St1, St2) zugeordnet ist,

   - daß zwischen diesen Steuersignalen (St1, St2) eine erste Phasenverschiebung (Ph1) besteht derart, daß im Ausgangssignal $(U_1)$ lediglich ein Puls (P1) während der Periodendauer (T) entsteht,

   - daß die Dauer des Pulses (P1) in Abhängigkeit von dem NF-Signal durch die erste Phasenverschiebung (Ph1) erzeugt wird und kleiner oder gleich der Ausgangs-Periodendauer (Ta) ist und

   - daß zwischen den Steuersignalen der Schaltergruppen (1 bis 4) eine zweite Phasenverschiebung (Ph2) vorhanden ist derart, daß im Ausgangssignal $(U_1)$ eine im wesentlichen periodische Pulsfolge mit der Ausgangs-Periodendauer (Ta) entsteht.

3. Schaltverstärker nach Anspruch 1 oder Anspruch 2, dadurch gekennzeichnet,

...

- daß die Schaltergruppen (1 bis 4) über ein Tiefpaßfilter (Tp) mit einer Last (R) verbunden sind,
- daß das Tiefpaßfilter (Tp) aus dem Ausgangssignal ($U_1$) im wesentlichen das darin enthaltene NF-Signal herausfiltert und
- daß das Tiefpaßfilter (Tp) eingangsseitig durch mindestens eine Freilaufdiode (Fr) abgeschlossen ist.

4. Schaltverstärker nach einem der vorhergehenden Ansprüche, dadurch gekennzeichnet,

- daß ein Dreiecksgenerator (Dr) vorhanden ist, der eine dreieckförmige Abtastspannung ($U_{ab}$) erzeugt, deren Periodendauer gleich derjenigen der Ausgangs-Periodendauer (Ta) ist,
- daß ein Komparator (K) vorhanden ist, an dessen einen Eingang (+) das zu verstärkende NF-Signal (NF) anliegt und an dessen anderen Eingang (-) die Abtastspannung ($U_{ab}$) anliegt,
- daß der Ausgang des Komparators mit einem Demultiplexer (Dem) verbunden ist, dessen Ausgänge jeweils mit einer der Schaltergruppen (1 bis 4) verbunden sind,
- daß die Ausgänge des Demultiplexers (Dem) mit der Grundfrequenz der Abtastspannung ($U_{ab}$) zyklisch umgeschaltet werden und
- daß innerhalb einer Ausgangs-Periodendauer (Ta) die zu einer Schaltergruppe (1) gehörenden Halbleiter-Schalter (S1, S2) in Abhängigkeit von der Steigung der Abtastspannung ($U_{ab}$) derart geschaltet werden, daß der Puls (P1) entsteht.

...

5. . Schaltverstärker nach einem der vorhergehenden Ansprüche. dadurch gekennzeichnet, daß mindestens zwei Teilspannungsgeräte (T1 bis Tn) hintereinander geschaltet sind zum Erzeugen des Ausgangssignales ($U_1$) und daß in den Teilspannungsgeräten entsprechende Schaltergruppen parallel ansteuerbar sind zur Erzeugung der erforderlichen Spannung und Stromstärke.

1/2

0226006

FIG. 1

FIG. 3

FIG. 2

2/2

0226006

Europäisches
Patentamt

**EUROPÄISCHER RECHERCHENBERICHT**

**0226006**
Nummer der Anmeldung

EP 86 11 4949

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | EP-A-0 025 234 (PATELHOLD PATENTVERWENTUNGS- & ELEKTRO-HOLDING AG) * Figuren 1-6; Seite 3, Zeile 15 - Seite 4, Zeile 6; Seite 6, Zeilen 4-26; Seite 7, Zeilen 16-25; Seite 9, Zeilen 1-18; Seite 10, Zeile 2 - Seite 12, Zeile 20 * | 1-5 | H 03 F 3/217 |
| | --- | | |
| A | EP-A-0 124 765 (BBC) * Figuren 1-3,5c,5e; Zusammenfassung; Seite 4, Zeilen 20-28; Seite 13, Zeilen 18-30 * | 1-3 | |
| | --- | | |
| A | US-A-4 510 456 (H.I. SWANSON) * Figur 1; Spalte 3, Zeilen 3-65 * | 1,3,4 | |
| | ----- | | RECHERCHIERTE SACHGEBIETE (Int. Cl.4) |
| | | | H 03 F |

Der vorliegende Recherchenbericht wurde für alle Patentansprüche erstellt.

| Recherchenort | Abschlußdatum der Recherche | Prüfer |
|---|---|---|
| DEN HAAG | 03-03-1987 | TYBERGHIEN G.M.P. |